(19) Europäisches Patentamt
European Patent Office
Office européen des brevets

(11) **EP 4 734 352 A1**

(12) **EUROPEAN PATENT APPLICATION**
published in accordance with Art. 153(4) EPC

(43) Date of publication:
**29.04.2026   Bulletin 2026/18**

(21) Application number: **24831835.4**

(22) Date of filing: **21.06.2024**

(51) International Patent Classification (IPC):
**H02N 2/04** *(2006.01)*    **H02N 2/12** *(2006.01)*

(52) Cooperative Patent Classification (CPC):
**H02N 2/04; H02N 2/12**

(86) International application number:
**PCT/JP2024/022483**

(87) International publication number:
**WO 2025/004974 (02.01.2025 Gazette 2025/01)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority:   **26.06.2023   JP 2023104194**

(71) Applicant: **Canon Kabushiki Kaisha
Tokyo, 146-8501 (JP)**

(72) Inventors:
• **UEBAYASHI, Akira
  Tokyo 146-8501 (JP)**
• **WATANABE, Takayuki
  Tokyo 146-8501 (JP)**

(74) Representative: **Canon Europe Limited
European Intellectual Property Group
4 Roundwood Avenue
Stockley Park
Uxbridge UB11 1AF (GB)**

(54) **VIBRATION TYPE ACTUATOR, ELECTRONIC APPARATUS, AND OPTICAL APPARATUS**

(57)    A vibration-type actuator includes a vibration member configured to include an electric-mechanical energy conversion element and an elastic member having a plate portion and projected portions which project in a same direction from a surface of the plate portion, a contact member configured to be in contact with the projected portions of the vibration member and move relative to the vibration member, a foamed member configured to be in contact with the vibration member, and a biasing member configured to press the vibration member toward the contact member via the foamed member, wherein, in a case where loss coefficient $\tan\delta$ of the foamed member is measured by viscoelastic measurement in which vibration is applied to the foamed member, the loss coefficient $\tan\delta$ of the foamed member measured at -20°C with vibration applied at a frequency of 1 Hz, is greater than the loss coefficient $\tan\delta$ of the foamed member, measured at 40°C with vibration applied at a frequency of 10 Hz.

**FIG.3**

133

**EP 4 734 352 A1**

## Description

Technical Field

The present disclosure relates to a vibration-type actuator, an electronic device, and an optical device.

Background Art

A vibration-type actuator includes a vibration member which includes an electric-mechanical energy conversion element, such as a piezoelectric element and an elastic member, and a contact member that is in pressure contact with the vibration member. The vibration-type actuator is utilized as a vibration wave motor, in which the contact member is relatively moved by using frictional force generated by driving force of vibration excited in the vibration member.

An outline of a structure and a drive principle of the vibration wave motor as one type of vibration-type actuator is described. The vibration wave motor includes a vibration member and a contact member that is in pressure contact with the vibration member by a biasing member. In this configuration, in order for the biasing member to apply uniform pressure to the vibration member, it is desirable that the biasing member have increased rigidity and be in contact with the vibration member. However, if a member having high rigidity is in contact with the vibration member, vibration generated by the vibration member is suppressed, and driving properties of the motor are degraded. Therefore, a structure in which a member serving as a vibration attenuation member, which does not suppress vibration generated by the vibration member, is disposed between the biasing member and the vibration member has been known.

In patent document (PTL) 1, sponge, expanded polystyrene, and felt are cited as examples of a supporting member for the vibration member, among which wool felt is disclosed as being particularly advantageous. In PTL 2, a member that does not interfere with vibration is used as a supporting member of a vibration member, and it is considered that the functions of this member are equivalent to the functions of the vibration attenuation member.

PTL 2 further describes a vibration-type actuator having a configuration including a foamed member disposed between the vibration member and the biasing member, in which an average equivalent circle diameter of cells included in the foamed member is set, whereby it is possible to stably acquire sufficient outputs over a long period of time.

Citation List

Patent Literature

PTL 1: Japanese Patent Application Laid-Open No. 1991-289371
PTL 2: Japanese Patent Application Laid-Open No. 2022-83146

Summary of Invention

Technical Problem

When a vibration-type actuator is driven, an unwanted frequency component, such as a frequency at one-half of an input driving frequency, may be excited. This may result in reducing driving efficiency and generation of abnormal noise (squealing).

In order to address the above-described issue, the present disclosure is directed to a vibration-type actuator capable of maintaining stable driving properties over a long period of time, while suppressing a decrease in driving efficiency and generation of abnormal noise (squealing). Further, the present disclosure is directed to an electronic device and an optical device using the vibration-type actuator capable of maintaining stable driving properties over a long period of time, while suppressing a decrease in driving efficiency and generation of abnormal noise (squealing).

Solution to Problem

According to an aspect of the present invention, a vibration-type actuator including a vibration member configured to include an electric-mechanical energy conversion element and an elastic member having a plate portion and projected portions which project in a same direction from a surface of the plate portion, a contact member configured to be in contact with the projected portions of the vibration member and move relative to the vibration member, a foamed member configured to be in contact with the vibration member, and a biasing member configured to press the vibration member toward the contact member via the foamed member, wherein, in a case where loss coefficient $\tan\delta$ of the foamed

member is measured by viscoelastic measurement in which vibration is applied to the foamed member, the loss coefficient tanδ of the foamed member measured at -20 degrees Celsius (°C) with vibration applied at a frequency of 1 hertz (Hz), is greater than the loss coefficient tanδ of the foamed member, measured at 40°C with vibration applied at a frequency of 10 Hz. Advantageous Effects of Invention

According to the present disclosure, it is possible to provide a vibration-type actuator capable of maintaining stable driving properties over a long period of time, while suppressing a decrease in driving efficiency and generation of abnormal noise (squealing). Further, according to the present disclosure, it is possible to provide an electronic device and an optical device using the vibration-type actuators capable of maintaining stable driving properties over a long period of time, while suppressing a decrease in driving efficiency and generation of abnormal noise (squealing).

Brief Description of Drawings

[Fig. 1A] Fig. 1A is a diagram illustrating a schematic structure of a vibration-type actuator according to the present disclosure, which uses a ring-shaped piezoelectric material or a rectangular piezoelectric material.
[Fig. 1B] Fig. 1B is a diagram illustrating a schematic structure of the vibration-type actuator according to the present disclosure, which uses a ring-shaped piezoelectric material or a rectangular piezoelectric material.
[Fig. 1C] Fig. 1C is a diagram illustrating the schematic structure of the vibration-type actuator according to the present disclosure, which uses a ring-shaped piezoelectric material or a rectangular piezoelectric material.
[Fig. 1D] Fig. 1D is a diagram illustrating the schematic structure of the vibration-type actuator according to the present disclosure, which uses a ring-shaped piezoelectric material or a rectangular piezoelectric material.
[Fig. 1E] Fig. 1E is a diagram illustrating the schematic structure of the vibration-type actuator according to the present disclosure, which uses a ring-shaped piezoelectric material or a rectangular piezoelectric material.
[Fig. 1F] Fig. 1F is a diagram illustrating the schematic structure of the vibration-type actuator according to the present disclosure, which uses a ring-shaped piezoelectric material or a rectangular piezoelectric material.
[Fig. 2A] Fig. 2A is a diagram illustrating two vibration modes of vibration generated by a vibration member according to the present disclosure including a rectangular piezoelectric material.
[Fig. 2B] Fig. 2B is a diagram illustrating the two vibration modes of vibration generated by the vibration member according to the present disclosure including the rectangular piezoelectric material.
[Fig. 3] Fig. 3 is a schematic diagram illustrating a cross-sectional view of a foamed member according to the present disclosure.
[Fig. 4A] Fig. 4A is a schematic diagram illustrating a side view of the foamed member according to the present disclosure.
[Fig. 4B] Fig. 4B is a schematic diagram illustrating a side view of the foamed member according to the present disclosure.
[Fig. 5] Fig. 5 illustrates an example of temperature dependency of viscoelastic properties of the foamed member according to the present disclosure.
[Fig. 6] Fig. 6 illustrates a synthetic curve acquired from the viscoelastic properties illustrated in Fig. 5.
[Fig. 7] Fig. 7 is a diagram illustrating an analysis result of electric current input to the vibration-type actuator, acquired by the fast Fourier transformation (FFT).
[Fig. 8] Fig. 8 is a diagram illustrating a schematic structure of an optical device according to the present disclosure.
[Fig. 9A] Fig. 9A illustrates driving properties of the vibration-type actuator according to one example of the present disclosure.
[Fig. 9B] Fig. 9B illustrates driving properties of the vibration-type actuator according to one example of the present disclosure.
[Fig. 10] Fig. 10 illustrates a synthetic curve acquired according to a time-temperature superposition principle.
[Fig. 11] Fig. 11 is a diagram illustrating examples of measurement results of speed and electric power with respect to frequency.

Description of Embodiments

The following describes embodiments for carrying out the present invention.
Inventors of the present disclosure found that degradation of driving properties and generation of abnormal noise (squealing) may occur in the vibration-type actuator using a foamed member. As a result of further study, the inventors found that it is possible to obtain a vibration-type actuator capable of maintaining stable driving properties over a long period of time while suppressing generation of abnormal noise by optimizing viscoelastic properties of the foamed member.

A vibration-type actuator according to the present invention includes a vibration member, a contact member, a foamed member, and a biasing member. The foamed member of the vibration-type actuator of the present invention is characterized in that, when vibration is applied and loss coefficient tanδ is measured by viscoelastic measurement, loss coefficient tanδ measured at a vibration frequency of 1 Hz at -20°C is greater than loss coefficient tanδ measured at a vibration frequency of 10 Hz at 40°C. In a case where the loss coefficient tanδ of the foamed member in a low-frequency range is greater than the loss coefficient tanδ of the foamed member in a high-frequency range when both of the loss coefficients tanδ are measured under the same temperature, the foamed member can effectively attenuate vibration generated in the low-frequency range and can also reduce generation of the abnormal noise.

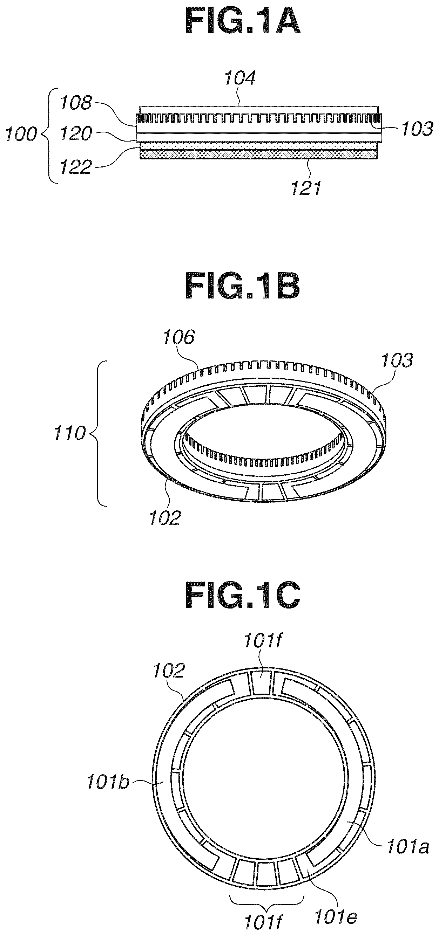

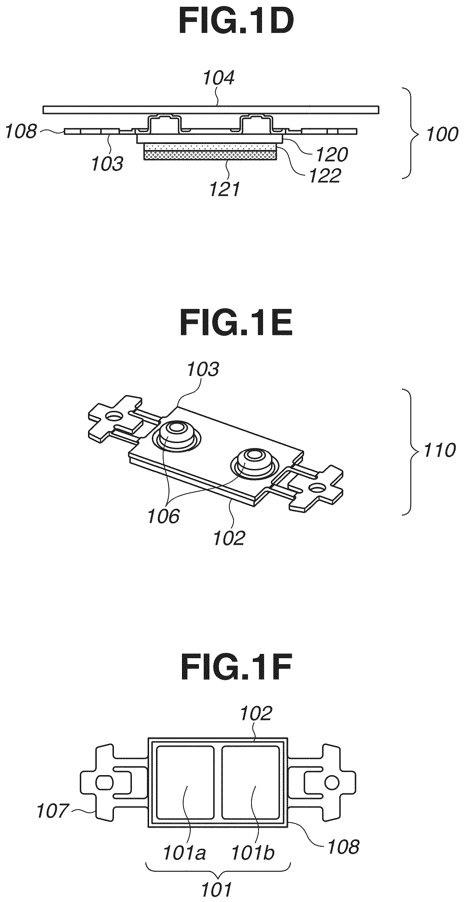

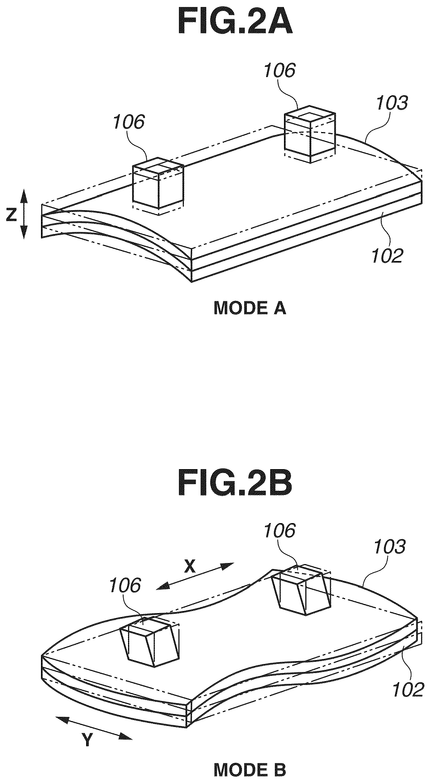

Schematic structures of the vibration-type actuator according to the present disclosure are illustrated in Figs. 1A to 1F and Figs. 2A and 2B. Figs. 1A and 1D illustrate side views of the vibration-type actuator, Figs. 1B and 1E illustrate perspective views of the vibration-type actuator, and Figs. 1C and 1F illustrate rear views of the vibration-type actuator. Fig. 2A illustrates a mode A of vibration modes, and Fig. 2B illustrates a mode B of the vibration modes.

A vibration member having a ring-shaped plate portion and a vibration member having a rectangular plate portion are used for the vibration-type actuators illustrated in Figs. 1A to 1F and Figs. 2A and 2B, respectively. A vibration-type actuator 100 according to the present invention includes an electric-mechanical energy conversion element 120 including an electrode 101 and a piezoelectric material 102. The vibration-type actuator 100 further includes an elastic member 103 having a plate portion 108 and projected portions 106 projecting in a same direction from a surface of the plate portion 108, and these members are sequentially arranged to configure a vibration member 110. The vibration-type actuator 100 further includes a contact member 104 being in contact with the projected portions 106. Further, the vibration-type actuator 100 includes a biasing member 121, which causes the vibration member 110 to be pressed (biased) against and brought into contact with the contact member 104, and a foamed member 122 arranged between the vibration member 110 and the biasing member 121.

The vibration member 110 and the contact member 104 move relatively to each other when the vibration member 110 is driven. A member capable of moving relative to the vibration member 110 can be used as the contact member 104. The contact member 104 is not limited to a member directly in contact with the vibration member 110 and can be a member indirectly in contact with the vibration member 110 via the other member. By the biasing member 121, a surface of the electric-mechanical energy conversion element 120 is pressed toward the contact member 104 by the biasing member 121 via the foamed member 122.

(Piezoelectric Material)

A shape of the piezoelectric material 102 is not limited, however, when a shape of the plate portion is a ring shape, it is desirable to use a ring-shaped piezoelectric material, and when a shape of the plate portion is a rectangle, it is desirable to use a rectangular piezoelectric material.

While a form of the piezoelectric material 102 is not limited, the piezoelectric material may be, for example, a piezoelectric material with no crystal orientation (i.e., sintered member), a crystal-oriented ceramic, or a piezoelectric single crystal. While a shape of the piezoelectric material is not limited, for example, a layered piezoelectric material or a single-plate piezoelectric material may be used in order to constitute a laminated member including an electrode and a piezoelectric material. The single-plate piezoelectric material is excellent in terms of cost. In order to drive the vibration-type actuator, polarization treatment is performed on the piezoelectric material. When an alternating electric field frequency applied to the polarized piezoelectric material approaches a resonant frequency of the piezoelectric material, the piezoelectric material significantly vibrates because of a resonance phenomenon.

In view of an environmental load, it is desirable that lead content of the piezoelectric material used for the electric-mechanical energy conversion element be 1000 ppm or less.

(Electrode)

In a case where a ring-shaped piezoelectric material is used, the electrode 101 divided in a circumferential direction is disposed in the piezoelectric material, so that a ring-shaped piezoelectric element is formed. The electrode 101 includes driving phase electrodes 101e and non-driving phase electrodes 101f. A length in the circumferential direction of the driving phase electrode is one-half of a wavelength λ of an oscillating wave generated in the circumferential direction of the ring-shaped piezoelectric element when alternating voltage is applied to the driving phase electrode. A length in the circumferential direction of the non-driving phase electrode (a ground electrode or a monitoring electrode) is one-fourth of the wavelength λ. The number of driving phase electrodes and the number of non-driving phase electrodes are changed in accordance with the number of travelling waves exciting the ring-shaped piezoelectric material. A piezoelectric material corresponding to each of the driving phase electrodes is polarized with voltage having a polarity different from a polarity of the adjacent region.

The driving phase electrodes are separated by the odd number of non-driving phase electrodes. After the polarization treatment, a first electrode 101a and a second electrode 101b are disposed in order to short-circuit two groups of driving phase electrodes separated by the non-driving phase electrodes. The first electrode 101a and the second electrode 101b are used to drive a vibration-type actuator using a ring-shaped piezoelectric material.

In a case using a rectangular piezoelectric material, a rectangular electrode 101 is disposed. The electrode 101 includes a first electrode 101a and a second electrode 101b. The first electrode 101a and the second electrode 101b are used for polarization treatment on the rectangular piezoelectric material and for driving the vibration-type actuator using the rectangular piezoelectric material.

The electrode is made of a metallic film having a thickness of 0.3 micrometers ($\mu$m) to 10 $\mu$m. Although a material of the electrode is not limited specifically, silver, gold, or platinum is generally used for the electrode. A manufacturing method of the electrode is not limited, and the electrode can be formed by a method, such as screen printing, sputtering, or vacuum vapor deposition. In order to manufacture the electric-mechanical energy conversion element whose lead content is 1000 parts per million (ppm) or less, it is necessary to use a paste or a target having a lead content of less than 1000 ppm also in the formation of the electrode.

(Elastic Member)

The elastic member 103 made of metal is desirable in terms of characteristics as an elastic member and workability. Aluminum, brass, and stainless steel can be given as examples of the metal usable for the elastic member 103. From among the stainless steel, use of martensite stainless steel is desirable, and SUS420J2 is particularly desirable. The elastic member includes the projected portions 106 being in contact with the contact member. In order to further improve the abrasion resistance of the projected portions, quenching, plating, and nitriding are performed on the elastic member 103.

A desirable shape of the plate portion of the elastic member is a rectangle. When the elastic member has a rectangular plate portion, the electric-mechanical energy conversion element is manufactured and processed more easily, enabling production of a small-size electric-mechanical energy conversion element. Consequently, it is possible to manufacture a small vibration-type actuator.

(Foamed Member)

As illustrated in Fig. 1A, the foamed member 122 is disposed on a surface of the electric-mechanical energy conversion element 120 opposite to the other surface where the elastic member 103 is disposed. The foamed member 122 is required to have a function as a vibration attenuation member while uniformly pressurizing the vibration member 110 against the contact member 104. The foamed member 122 functions as a vibration attenuation member to absorb and attenuate vibration from an adjacent member, and if the driving properties are not degraded, the foamed member 122 can be disposed separately.

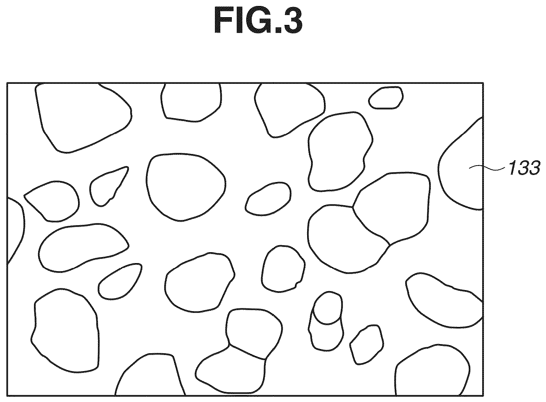

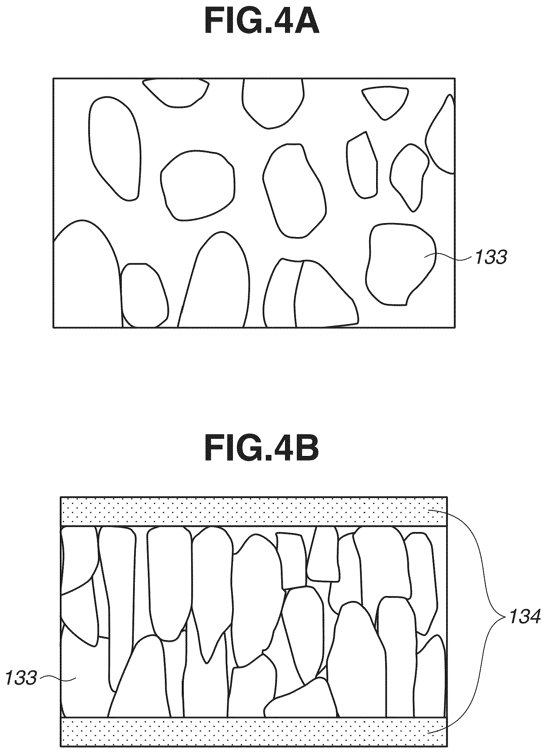

A cross-sectional view of a foamed member according to the present disclosure, viewed in a horizontal direction (X-Y plane) is illustrated in Fig. 3. Further, side views of foamed members according to the present disclosure, viewed in a vertical direction (Z direction) are illustrated in Figs. 4A and 4B. A side view of the foamed member without a skin layer on its surface is illustrated in Fig. 4A, and a side view of the foamed member having a skin layer on its surface is illustrated in Fig. 4B.

In a case where vibration is applied to the foamed member and loss coefficient tan$\delta$ of the foamed member is measured by viscoelastic measurement, loss coefficient tan$\delta$ of the foamed member measured at a vibration frequency of 1 Hz at -20°C is greater than loss coefficient tan$\delta$ measured at a vibration frequency of 10 Hz at 40°C. When the above-described relationship is satisfied, it is possible to reduce generation of abnormal noise caused by excitation in a low-frequency range, while suppressing degradation of driving properties of the vibration-type actuator.

A value of the loss coefficient tan$\delta$ of the foamed member can be measured by a dynamic viscoelasticity measurement apparatus. The dynamic viscoelasticity measurement apparatus applies sinusoidal vibration strain to the foamed member and observes stress variation, so that frequency dependency of a storage elastic modulus and a loss elastic modulus is measured as viscoelastic properties. Further, the loss coefficient tan$\delta$ is defined as a loss tangent, i.e., a value obtained by dividing the loss elastic modulus by the storage elastic modulus, and can be used as an index for damping capability.

A mode in which a member is pulled or twisted while holding both ends of the member is used as a method for applying the sinusoidal vibration strain to the foamed member. Further, a mode in which force is applied in a thickness direction of a member, or a mode in which a member is twisted while applying force in a thickness direction is also used. The method can be selected according to a shape and a size of the foamed member to be measured.

It is possible to obtain changes in the viscoelastic properties with temperatures by applying sinusoidal vibration strain to the foamed member while changing temperatures of the measurement environment and observing the stress variation. The frequency dependency of the viscoelastic properties is evaluated while changing the measurement temperature, and a frequency range of the frequency dependency measurement can be expanded by applying the temperature-time superposition principle. The temperature-time superposition principle is a rule for converting stress relaxation behavior at different relaxation times by shifting conversion by utilizing the temperature-dependent stress relaxation behavior of the viscoelastic material. A synthetic curve illustrating a relationship between time and stress is created by shifting the measured data to a reference temperature. This synthetic curve is also referred to as a master curve, and data can be plotted as loss coefficient tanδ for the frequency. As a result, it is possible to acquire viscoelastic properties in a high-frequency range, e.g., a frequency range of 1000 hertz (Hz) to 100 kilohertz (kHz), which cannot easily be measured directly. A shift amount for the temperature can be approximated by the Williams-Landel-Ferry (WLF) equation or the Arrhenius equation.

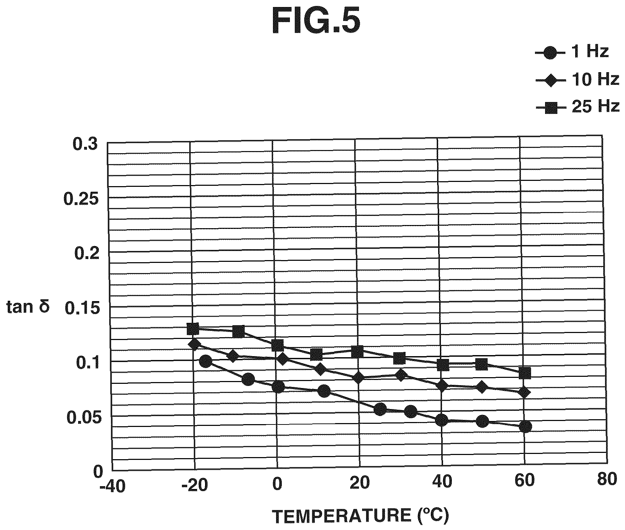

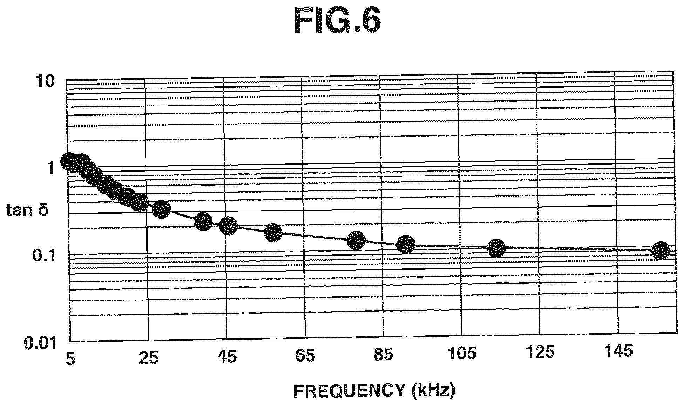

Fig. 5 illustrates some of the results of the viscoelastic properties, acquired by applying vibration in a frequency range of 0.1 Hz to 50 Hz while changing the measurement temperatures from -20°C to 60°C, and more specifically, illustrates results of temperature dependency at frequencies of 1.58 Hz, 12.6 Hz, and 25.1 Hz. Further, Fig. 6 illustrates a result of a synthetic curve acquired from the above-described measurement results when the reference temperature is 23°C.

As illustrated in the synthetic curve in Fig. 6, for example, a loss coefficient tanδ at a frequency of 50 kilohertz (kHz) is greater than a loss coefficient tanδ at a frequency of 100 kHz, indicating that the damping capability is higher in the low frequency range. The characteristic of the above-described foamed member, having the high damping capability in a low frequency range, is that loss coefficient tanδ measured at a vibration frequency of 1 Hz at a temperature of -20°C is greater than loss coefficient tanδ measured at a frequency of 10 Hz at a temperature of 40°C.

Herein, -20°C is higher than a glass-transition temperature and is a temperature at which the viscoelastic properties can stably be acquired. Further, 40°C is higher than a reference temperature for creating a synthetic curve and is a temperature at which deformation caused by heat is small, and the viscoelastic properties can be acquired stably. Particularly, because the viscoelastic properties considerably change at a temperature close to the glass-transition temperature, it is not desirable to use a measurement result which includes a measurement result acquired at the glass-transition temperature. When measurement of viscoelastic properties of the foamed member according to the present invention is performed, the foamed member is kept under the pressure force adopted in the vibration-type actuator, e.g., 600 grams per square centimeter (g/cm$^2$) to 700 g/cm$^2$. This is desirable because it is considered that the viscoelastic properties of the foamed member become stable when the foamed member is preloaded and maintained under the specified pressure condition.

In the synthetic curve which is acquired based on the time-temperature superposition principle with a reference temperature of 23°C, it is desirable that loss coefficient tanδ at a frequency of 30 Hz be 0.2 or more, in order to efficiently reduce generation of the abnormal noise. Further, in the synthetic curve which is acquired based on the time-temperature superposition principle with the reference temperature of 23°C, it is desirable that the curve include a frequency range in which the loss coefficient decreases as the frequency increases, because such a curve is expected to effectively suppress excitation in the low-frequency side.

It is also desirable that loss coefficient tanδ of the foamed member, measured at -20°C while vibration at a frequency of 10 Hz is applied, be 0.1 or more in order to efficiently attenuate vibration in the low-frequency range.

As for the foamed member, it is desirable to include a siloxane bond consisting of silicon and oxygen (Si-O-Si). When the foamed member includes a siloxane bond consisting of silicon and oxygen (Si-O-Si), mobility of molecules constituting the foamed member is improved, and a glass-transition temperature of the foamed member can be lower than -30°C, which is the lower limit of an operating temperature range. Thus, the viscoelastic properties can be acquired stably in a wide temperature range of high temperatures to low temperatures, so that it is possible to expect that the foamed member maintains physical properties equivalent to physical properties at the room temperature.

In the course of manufacturing the foamed member, when thermal hardening or cross-linking hardening using a mixture of two-component materials is performed, density of cross-linking points in the foamed member and an average equivalent circle diameter of bubbles can be changed by controlling a heating temperature and a heating period. Heat treatment in which a foamed material containing silicone resin, including bubbles having an average equivalent circle diameter greater than 120 μm, is kept under the pressure of 600 g/cm$^2$ or more and 700 g/cm$^2$ or less, at the temperatures of 60°C or more and 80°C or less is performed, so that a foamed member has been acquired. It is desirable to perform pressure heat treatment as it can be considered that a structure of the foamed member becomes stable.

It is desirable to use a sponge containing silicone rubber as a foamed member. An equivalent effect can also be achieved with a sponge containing silicone rubber in which a methyl group is partially replaced with a vinyl group or a phenyl group. The silicone sponge is desirable because a degree of change in the volume of the silicone sponge in the thickness direction under a pressurized condition is smaller than a degree of change in the volume of felt, and the silicone sponge is excellent in long-term stability. For example, in a case where felt is kept for 500 hours under the pressure of 600 g/cm$^2$ or more and 700 g/cm$^2$ or less at the room temperature, the felt is compressed so that a thickness is reduced to 50% approximately, and the thickness is not restored to the initial thickness even if the felt is released from the pressure. On the other hand, when the silicone sponge is released from the pressure, a thickness is restored to the initial thickness, so that a degree of change in the volume is small.

A characteristic of the foamed member is that an average equivalent circle diameter of the bubbles contained in the foamed member is greater than 120 μm.

It is desirable that an average equivalent circle diameter of bubbles contained in the foamed member 122 be greater than 120 μm. Because of the bubbles present in the foamed member, the foamed member can have a spring property and can also function as a vibration attenuation member while uniformly pressing the vibration member 110 against the contact member 104.

It is desirable that an average equivalent circle diameter be calculated from a cross-sectional shape of the foamed member. When the average equivalent circle diameter of bubbles in a cross-sectional face of the foamed member is greater than 120 μm, the foamed member can apply uniform pressure to the vibration member without interfering with vibration generated by the vibration member while maintaining driving properties of a motor.

The average equivalent circle diameter of the foamed member 122 can be obtained using image processing or the like that is executed on a cross-sectional image acquired by cross-sectional observation. In order to perform cross-sectional observation, a cross-sectional face is exposed by sectioning a sample. Then, the cross-sectional face is observed by using an optical microscope of a laser microscope. Alternatively, a cross-sectional image may be acquired through a non-destructive method using an X-ray computed tomography (CT) scanner. Further, if it is possible to check a shape of the bubble, a surface which is in contact with the electric-mechanical energy conversion element 120 may be treated as a cross-sectional shape. Either image processing software optimized for a microscope or image processing software available in the market can be used. When the average equivalent circle diameter is to be calculated, it is desirable to observe a large number of bubbles because various sizes of bubbles are present. Specifically, it is desirable to calculate the average equivalent circle diameter based on 50 or more bubbles.

As illustrated in Fig. 4B, the foamed member according to the present disclosure may have pillar-like bubbles, and may also have a skin layer on a surface of the foamed member. As illustrated in Fig. 4B, in a case where the skin layer is present on the surface, it is not possible to precisely check the bubbles from the surface. In this case, it is desirable to expose a cross-sectional face by sectioning. The average equivalent circle diameter can be calculated by executing image processing on the acquired tomographic image.

It is desirable that bubbles in the foamed member mainly include closed-cell bubbles. A closed-cell bubble refers to a bubble which does not connect a front face and a back face of the foamed member. The closed-cell bubble does not easily transmit gas and liquid. Therefore, it is desirable for the foamed member to include closed-cell bubbles in order to have a spring property. On the other hand, open-cell bubbles are not desirable because they are connected to each other, which facilitates the ingress and egress of air, making the material more susceptible to collapse under pressure, and due to its inferior elasticity, there is a risk that uniform pressure cannot be applied to the vibration member, and the vibration damping function may be reduced. It is desirable that the number of closed-cell bubbles be greater than the number of open-cell bubbles. In other words, it is desirable that the closed-cell bubbles account for 50% or more of the bubbles contained in the foamed member. In this regard, the percentage can be calculated from a tomographic image including 50 or more bubbles.

It is more desirable that the average equivalent circle diameter of the bubbles included in the foamed member be 200 μm or more. In order to stably operate the vibration-type actuator in an operating temperature range (for example, -30°C to 60°C), it is effective to use a piezoelectric material having a phase transition temperature of -10°C or less in the vibration-type actuator. In other words, it is effective to use a piezoelectric material whose piezoelectric properties at -10°C are greater than piezoelectric properties at room temperature, in the vibration-type actuator. In this regard, by setting the average equivalent circle diameter of the bubbles to be 200 μm or more, it is possible to maintain the effect exerted as a vibration attenuation member in a low-temperature range, so that driving efficiency can be improved. It is more desirable that the average equivalent circle diameter of the bubbles be 300 μm or more.

It is desirable that the average equivalent circle diameter of the foamed member be smaller than one-half of a thickness t of the foamed member. In this way, the foamed member can function as a vibration attenuation member while uniformly pressurizing the vibration member. It is more desirable that the foamed member with average equivalent circle diameter is smaller than one-third of the thickness t be used.

(Contact Member)

In view of rigidity, it is desirable to use stainless steel for the contact member 104. From among the stainless steel, use of martensite stainless steel is desirable, and SUS420J2 is most desirable. Since the contact member 104 has to be excellent in abrasion resistance because the contact member 104 is frictionally in contact with the elastic member 103, nitriding treatment and anodizing treatment are performed on the surface of the contact member 104. Frictional force caused by pressure contact acts between the projected portions 106 and the contact member 104. Tip portions of the projected portions 106 are elliptically vibrated because of the vibration generated by the electric-mechanical energy conversion element 120, so that driving force (thrust force) for driving the contact member 104 can be generated. The contact member is generally referred to as "slider" or "rotor".

The term "contact member" refers to a member which is in contact with a vibration member and moves relative to the vibration member due to vibration generated by the vibration member. The contact of the contact member with the vibration member is not limited to direct contact in which the other member is not interposed between the contact member and the vibration member. As long as the contact member moves relative to the vibration member due to vibration generated by the vibration member, the contact of the contact member with the vibration member may be indirect contact in which the other member is interposed between the contact member and the vibration member. "The other member" is not limited to a member (for example, a high-friction member consisting of a sintered member) independent from the contact member and the vibration member. "The other member" may be a portion that has been formed on a surface of the contact member or the vibration member by surface treatment, such as plating or nitriding.

(Piezoelectric Vibration Member)

In the ring-shaped piezoelectric element, because a piezoelectric material which is in contact with the adjacent driving phase electrodes is polarized in a polarity different from a polarity of the adjacent driving phase electrodes, stretching polarities in the region of the piezoelectric material are alternately inverted at a pitch of A/2 when electric fields of same polarity are applied to the driving phase electrodes 101e. When alternating voltage is applied to the first electrode 101a, a first standing wave having a wavelength $\lambda$ is generated across the entire circumference of the vibration member. Although a second standing wave is similarly generated when alternating voltage is applied to the second electrode 101b, a position of the wave rotationally moves by only $\lambda/4$ in the circumferential direction with respect to the first standing wave. On the other hand, when two types of alternating voltage of a same frequency having a temporal phase difference n/2 are applied to the first and the second electrodes, the following progressive wave is generated. In other words, as a result of synthesizing the first and the second standing waves, a progressive wave (travelling along the ring, with a wavenumber n of a wavelength $\lambda$) of bending vibration, i.e., vibration having vibration amplitude perpendicular to a surface of the vibration member, travelling in the circumferential direction, is generated across the entire circumference of the vibration member.

When the progressive wave of bending vibration (hereinafter, simply referred to as "bending vibration wave") is generated, each of points on the surface of the vibration plate included in the vibration member performs an elliptic motion, and thus a moving member in contact with the surface is rotated by receiving frictional force (driving force) in the circumferential direction from the vibration plate. A rotation direction of the moving member can be inverted when the positive and negative phase difference of alternating voltages applied to the first electrode and the second electrode are switched. Further, a rotation speed can be controlled by the frequency and amplitude of the alternating voltage applied to the first electrode and the second electrode.

Figs. 2A and 2B illustrate two vibration modes of the vibration member according to the present invention including a rectangular piezoelectric material. The first electrode 101a and the second electrode 101b are disposed in the rectangular piezoelectric material, and regions where the first electrode 101a and the second electrode 101b are disposed are referred to as a first region and a second region, respectively.

• Mode A

When both the first region and the second region expand or contract, a first bending vibration mode (mode A) is generated. In the mode A, a phase difference of alternating voltages VA and VB applied to the first electrode 101a and the second electrode 101b is 0°, and vibration is induced most intensively when the frequency is close to the resonant frequency of the mode A. The mode A is a primary out-of-plane vibration mode in which two nodes (points where the amplitude is minimized) appear substantially parallel to a long side of the vibration member 110. The two projected portions 106 projected in a same direction from the elastic member are disposed in the vicinities of anti-nodes (points where the amplitude is maximized) in the mode A. Therefore, tip surfaces of the projected portions 106 reciprocate in a Z direction through the vibration mode A.

• Mode B

When the second region contracts and expands along with expansion and contraction of the first region, a second bending vibration mode (i.e., mode B) is generated. In the mode B, a phase difference of the alternating voltages VA and VB applied to the first electrode 101a and the second electrode 101b is 180°, and vibration is induced most intensively when the frequency is close to the resonant frequency of the mode B. The mode B is a secondary out-of-plane vibration mode in which three nodes appear substantially parallel to a short side of the vibration member 110. The projected portions 106 projected from the elastic member are disposed in the vicinities of the nodes in the mode B. Therefore, tip surfaces of the projected portions 106 reciprocate in an X direction through the mode B.

In the vibration-type actuator 100, when a phase difference of the alternating voltages VA and VB is 0° to $\pm 180°$,

the mode A and the mode B are induced at the same time, so that elliptical vibration is induced at the projected portions 106 of the elastic member. The vibration-type actuator driven in the modes A and B, which uses a rectangular piezoelectric material, is desirable due to ease of miniaturization of the vibration-type actuator.

It is desirable that two projected portions projecting in a same direction from a surface of the plate portion are disposed. The vibration-type actuator driven in the modes A and B as illustrated in Figs. 2A and 2B, which uses a rectangular piezoelectric material, is desirable due to ease of miniaturization of the vibration-type actuator.

In order to prevent the foamed member, deformed by pressurization, from interfering with vibration, it is desirable that a size of a portion where the foamed member is in contact with the electric-mechanical energy conversion element be smaller than a size of a planar portion of the electric-mechanical energy conversion element including that portion. It is also desirable that the foamed member be smaller than the electric-mechanical energy conversion element. It is possible to expect an effect of preventing an issue in which the foamed member is deformed and extends toward a side surface of the electric-mechanical energy conversion element serving as a piezoelectric element, or is deformed and interferes with peripheral members, which may result in interfering with vibration. It is also desirable that the foamed member be smaller than the elastic member. If the foamed member is larger than the elastic member, there is a risk that the foamed member is deformed and suppresses vibration by interfering with the peripheral members. Therefore, by setting the foamed member to be smaller than the elastic member, it is possible to expect an effect of preventing a problem of suppressing the vibration.

(Unwanted Frequency Component)

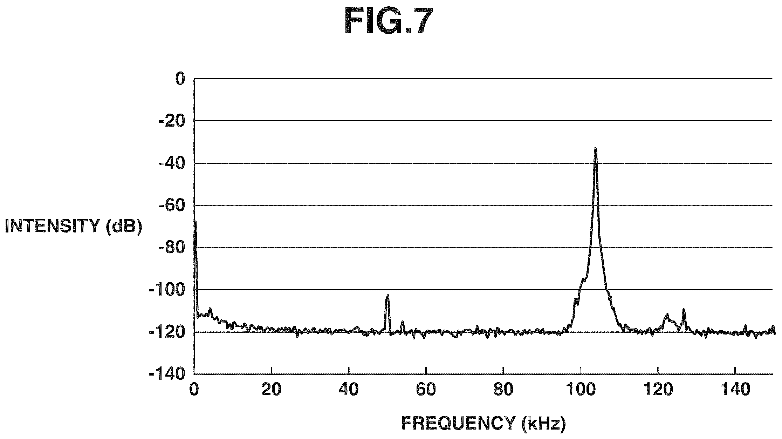

There is a case where an unwanted frequency component, such as a frequency that is one-half of an input driving frequency, is excited when the vibration-type actuator is driven. Fig. 7 illustrates an analysis result of electric current input to the vibration-type actuator when the input driving frequency is 104 kHz, acquired by fast Fourier transformation (FFT). Separately from the driving frequency of 104 kHz, a large peak can be observed in a vicinity of 52 kHz that is a frequency at one-half of the driving frequency. One of the coefficients that causes occurrence of a significant frequency component having intensity different from that of the driving frequency is considered to be that the unwanted vibration, generated from the constituent components of the vibration-type actuator, are transmitted to the piezoelectric vibration member. As a result, lowering of driving efficiency and generation of abnormal noise (squealing) occur because of the unwanted vibration. The vibration-type actuator using the foamed member according to the present disclosure can suppress lowering of driving efficiency and can reduce generation of abnormal noise (squealing) by reducing the above-described unwanted vibration.

(Composition of Piezoelectric Material)

The composition of the piezoelectric material 102 is not particularly limited as long as the piezoelectric material 102 can be used as the vibration-type actuator.

Generally, a material of a lead zirconate titanate (PZT) series is used as a piezoelectric material for the piezoelectric material. However, in recent years, a negative effect of lead on the environment has been acknowledged as a problem. Therefore, use of a piezoelectric material using perovskite-type metallic oxide which does not contain lead (i.e., lead content is less than 1000 ppm) has been suggested. For example, the lead content can be measured by inductively coupled plasma (ICP) optical emission spectroscopic analysis.

It is more desirable that a main component of a lead-free piezoelectric material which does not contain lead be a material of a barium titanate series.

It is desirable that the piezoelectric material be made of a material of a barium titanate series because the material of the barium titanate series has a high piezoelectric constant and can be manufactured relatively easily. Herein, examples of the material of the barium titanate series include barium titanate ($BaTiO_3$), barium calcium titanate (($Ba, Ca)TiO_3$), barium zirconate titanate ($Ba(Ti, Zr)O_3$), and barium calcium zirconate titanate (($Ba, Ca) (Ti, Zr)O_3$). Further, examples of compositions include sodium niobate-barium titanate ($NaNbO_3$-$BaTiO_3$), bismuth sodium titanate-barium titanate, and bismuth potassium titanate-barium titanate. Then, the material of the barium titanate series refers to a material containing the above-described compositions as main components. A main component refers to a material whose weight fraction is 10% or more.

Further, a piezoelectric material which contains the above-described compositions or a combination of these compositions as the main components can be used for the vibration-type actuator 100 according to the present invention.

Especially, the following materials are more desirable because temperature dependency of the piezoelectric properties is excellent in the operating temperature range, and both the piezoelectric constant and the mechanical quality coefficient of the piezoelectric material can be simultaneously achieved. In other words, it is desirable that the piezoelectric material contains barium calcium zirconate titanate (($Ba, Ca) (Ti, Zr)O_3$) and sodium niobate-barium titanate ($NaNbO_3$-$BaTiO_3$) as main components.

It is desirable that the piezoelectric material contains barium calcium zirconate titanate (hereinafter, referred to as "BCTZ") as a main component. When BCTZ is contained as a main component, piezoelectricity of BCTZ can be adjusted depending on the purpose of use, by adjusting the amount of calcium (Ca) and zirconium (Zr). Further, it is possible to reduce the amount of costly niobium employed.

It is desirable that a piezoelectric material which contains a perovskite-type metallic oxide including barium (Ba), calcium (Ca), titanium (Ti), and zirconium (Zr), and manganese (Mn) is used. It is desirable that a molar ratio x of Ca to a sum of Ba and Ca satisfy a condition $0.02 \leq x \leq 0.30$. It is desirable that a molar ratio y of Zr to a sum of Ti and Zr satisfy conditions $0.020 \leq y \leq 0.095$ and $y \leq x$, and a molar ratio $\alpha$ of a molar quantity of Ba and Ca and a molar quantity of Ti and Zr satisfy a condition $0.9955 \leq \alpha \leq 1.01$. It is desirable that an amount of Mn contained in 100 part-by-weight of oxide be 0.02 part-by-weight or more and 1.0 part-by-weight or less in metal conversion.

The above-described piezoelectric material can be defined by the following formula (1):

$$(Ba_{1-x}Ca_x)_\alpha(Ti_{1-y}Zr_y)O_3 \qquad (1)$$

However, it is desirable that an amount of metallic components other than the main component, contained in the piezoelectric material which contains the perovskite-type metallic oxide as a main component, defined by the following formulas:

$$0.986 \leq \alpha \leq 1.100 \qquad ,$$

$$0.02 \leq x \leq 0.30 \qquad ,$$

and

$$0.02 \leq y \leq 0.095,$$

be 1 part-by-weight or less in metal conversion with respect to 100 part-by-weight of the metallic oxide.

Specifically, it is desirable that the metallic oxide contain Mn, and that the amount of Mn contained in 100 part-by-weight of the metallic oxide be 0.02 part-by-weight or more and 0.40 part-by-weight or less in metal conversion. In a case where the amount of Mn falling within the above-described range is contained, an insulation property and a mechanical quality coefficient Qm are improved. Herein, the mechanical quality coefficient Qm is a coefficient which represents an elastic loss caused by vibration when the piezoelectric material is evaluated as a vibration member, and a magnitude of the mechanical quality coefficient Qm is observed as sharpness of a resonant curve in impedance measurement. In other words, the mechanical quality coefficient Qm is a constant which represents sharpness of resonance of the vibration member. When the mechanical quality coefficient Qm is high, a strain amount of the piezoelectric material becomes greater in the vicinity of the resonance frequency, so that the piezoelectric material can be vibrated efficiently.

In the metallic oxide defined by the general formula (1), the metallic elements located in an A-site of the perovskite structure are Ba and Ca, and the metallic elements located in a B-site of the perovskite structure are Ti and Zr. However, part of Ba and Ca may be located in the B-site. Similarly, part of Ti and Zr may be located in the A-site.

In the general expression (1), while a molar ratio of the elements located in the B-site to the elements of oxygen (O) is one-to-three (1:3), even if the molar ratio is slightly deviated, the metallic oxide is included in the scope of the present disclosure as long as the metallic oxide has the perovskite structure as a main phase.

It is possible to determine whether the metallic oxide has a perovskite structure by a method, such as an X-ray diffraction method or an electron diffraction method.

A value of the molar ratio x of Ca located in the A-site expressed in the general expression (1) falls within a range of $0.02 \leq x \leq 0.30$. When part of Ba of the perovskite-type barium titanate is replaced with Ca within the above-described range, a phase transition temperature of an orthorhombic system and a tetragonal system is shifted to a low temperature side. Therefore, stable piezoelectric vibration can be achieved within a driving temperature range of the vibration-type actuator. However, in a case where a value of the molar ratio x is greater than 0.30, the piezoelectric constant of the piezoelectric material is not sufficient, and thus there is a risk that the performance of the vibration-type actuator becomes insufficient. On the other hand, in a case where a value of the molar ratio x is less than 0.02, there is a risk that a dielectric loss (tan $\delta$) is increased. When the dielectric loss is increased, an amount of heat generation is increased when the vibration-type actuator is driven by applying voltage to the piezoelectric material, and driving efficiency of the motor is lowered, which may result in a risk that power consumption increases.

In the general expression (1), a value of the molar ratio y of Zr located in the B-site falls within a range of $0.02 \leq y \leq 0.1$. In a case where a value of the molar ratio y is greater than 0.1, Td becomes less than 80°C, which is undesirable because a temperature range in which the vibration-type actuator is usable becomes less than 80°C.

In this specification, "Td" refers to a temperature that is the lowest temperature at which a piezoelectric constant of the piezoelectric material heated to Td from a room temperature and cooled to the room temperature again after one week from polarization treatment decreases by more than 10%, when compared to a piezoelectric constant before heating.

Further, in the general expression (1), it is desirable that $\alpha$ of the molar quantity of Ba and Ca in the A-site and the molar quantity of Ti and Zr in the B-site fall within a range of $0.9955 \leq \alpha \leq 1.010$. In a case where $\alpha$ is less than 0.9955, abnormal grain growth occurs easily in the crystalline grains constituting the piezoelectric material, which results in degradation in mechanical strength of the piezoelectric material. On the other hand, in a case where $\alpha$ is greater than 1.010, the piezoelectric material is not densified, and consequently, the piezoelectric material does not achieve sufficient densification, and its insulating characteristics become significantly brittle.

A method for measuring the composition of the piezoelectric material is not particularly limited. Methods, such as X-ray fluorescence analysis, ICP optical emission spectroscopic analysis, and atomic absorption analysis, can be used. A weight ratio and a composition ratio of each element contained in the piezoelectric material can be calculated by any of the above-described measurement methods.

In metal conversion for expressing the contained amount of Mn, the contained amounts of metals, such as Ba, Ca, Ti, Zr, and Mn measured from the piezoelectric material by a method, such as fluorescent X-ray analysis (XRF), ICP optical emission spectroscopic analysis, or atomic absorption analysis are calculated. Then, by converting constituent elements of the metal oxide defined by the general formula (1) into their respective oxides based on the calculated contained amounts, a value calculated by a ratio of a total weight to a weight of Mn, when the total weight is 100, is acquired.

In a case where the contained amount of Mn is less than 0.02 part-by-weight, there is a risk that an effect of the polarization treatment necessary to drive the vibration-type actuator is not sufficient. On the other hand, in a case where the contained amount of Mn is greater than 0.40 part-by-weight, there are risks that the piezoelectric properties of the piezoelectric material are not sufficient, and that a crystal having a hexagonal crystalline structure which does not have a piezoelectric property is developed. Mn is not limited to a manganese metal, and the form of content is not taken into consideration as long as Mn is contained in the piezoelectric material as a manganese component. For example, Mn may be included in the B-site as a solid solution, or may be included in a grain boundary. In terms of the insulation property and sinterability, a desirable form of content is a solid solution in the B-site.

It is desirable that the piezoelectric material contains bismuth (Bi) of 0.042 part-by-weight or more and 0.850 part-by-weight or less in metal conversion.

Based on 100 part-by-weight of the metallic oxide defined by the general formula (1), the piezoelectric material may contain Bi of 0.85 part-by-weight or less in metal conversion. For example, the contained amount of Bi with respect to the metallic oxide can be measured by ICP optical emission spectroscopic analysis. Bi may be included in a grain boundary of the ceramic-like piezoelectric material, or may be included in the perovskite structure of barium calcium zirconate titanate $((Ba, Ca) (Ti, Zr)O_3)$ as a solid solution. In a case where Bi is present in the grain boundary, intergranular friction is reduced, increasing the mechanical quality factor. On the other hand, in a case where Bi is incorporated into a solid solution which forms the perovskite structure, a phase transition temperature becomes low. Therefore, the temperature dependency of the piezoelectric constant is lowered, and the mechanical quality coefficient is further increased. It is desirable that Bi incorporated into the solid solution be located in the A-site because a charge balance with Mn is improved.

The piezoelectric material may contain components (hereinafter, referred to as "secondary components") other than the elements, Mn and Bi, included in the general expression (1), within a range in which the properties of the piezoelectric material are not fluctuated. It is desirable that a total of the secondary components be less than 1.2 part-by-weight with respect to 100 part-by-weight of the metallic oxide defined by the general formula (1). When the secondary components exceeds 1.2 part-by-weight, there is a risk that the piezoelectric properties and the insulation properties of the piezoelectric material are degraded. A resonance frequency of the lead-free piezoelectric material tends to be high in comparison to the lead-based piezoelectric material, because the Young's modulus of the lead-free piezoelectric material is high. In a case where the resonance frequency is high, the vibration member vibrates more frequently, so that the vibration-type actuator becomes sensitive to change of the vibration attenuation member arranged between the biasing member and the vibration member. Therefore, with respect to the vibration-type actuator using a non-leaded piezoelectric material, it is desirable to use the foamed member having high damping capability and excellent in long-term stability.

Because the temperature dependency of the piezoelectric properties is excellent in the operating temperature range of the vibration-type actuator (e.g., -30°C to 60°C), it is more desirable that the phase transition temperature be -10°C or less.

When the temperature is decreased from a room temperature, transition of a phase from a tetragonal system to an orthorhombic system sequentially occurs in the piezoelectric material of the present disclosure. A phase transition temperature described in this specification refers to a temperature at which transition of a phase occurs. A permittivity is measured while changing temperatures, and a temperature at which a value calculated by differentiating the permittivity with a sample temperature becomes maximum is acquired as a phase transition temperature. A crystalline system can be evaluated through a method, such as X-ray diffraction, electron diffraction, or Raman scattering. In the vicinity of the phase transition temperature, the permittivity and the electromechanical coupling coefficient become maximum, and the Young's modulus becomes minimum. A piezoelectric constant is a function of these three parameters. In the vicinity of the phase transition temperature, the piezoelectric constant exhibits either a peak or an inflection point.

(Electronic Device)

An electronic device according to the present invention includes the vibration-type actuator according to the present invention, a member connected to a contact member of the vibration-type actuator, and a member position detection unit (e.g., encoder). The electronic device detects a position of the member and operates the vibration-type actuator until the member reaches a target position, so that the electronic device can precisely control the position of the member.

(Optical Device)

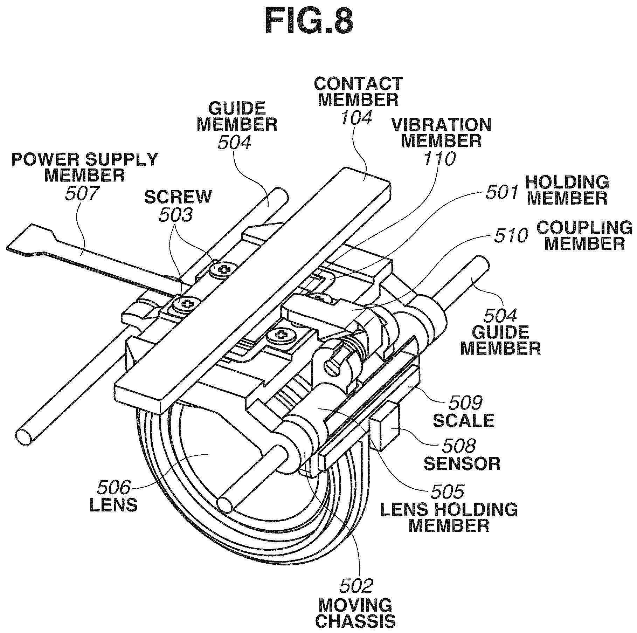

An optical device according to the present invention includes the electronic device according to the present invention and at least any one of an optical element and an image sensor. Fig. 8 is a schematic diagram illustrating an embodiment of the optical device (a focus lens portion of a lens barrel apparatus) according to the present invention. In Fig. 8, in a state similar to the state illustrated in Fig. 1D, a vibration member 110 having a rectangular piezoelectric material is in pressure contact with a contact member (slider) 104.

A power supply member 507 is connected to one side of a surface having a first region and a second region. When a desired voltage is applied to the vibration member 110 by a voltage input unit (not illustrated) via the power supply member 507, projected portions of an elastic member (not illustrated) make elliptic motions. A holding member 501 is connected to the vibration member 110 and configured to prevent generation of unwanted vibration. A moving chassis 502 is fixed to the holding member 501 with screws 503 and integrated with the vibration member 110. The electronic device according to the present invention is formed by these members. The moving chassis 502 is attached to guide members 504, so that the electronic device of the present disclosure can move linearly in both directions (i.e., forward and reverse directions) along the guide members 504.

Next, a lens 506 (optical member) serving as a focus lens of a lens barrel apparatus is described. The lens 506 is fixed to a lens holding member 505 and has an optical axis (not illustrated) parallel to a moving direction of the vibration-type actuator. Similar to the vibration-type actuator, the lens holding member 505 moves linearly along the below-described two guide members 504 to execute focusing operation for adjusting a focal position. The moving chassis 502 and the lens holding member 505 are engaged by the two guide members 504, so that the moving chassis 502 and the lens holding member 505 can move linearly. With the above-described configuration, the moving chassis 502 and the lens holding member 505 can move linearly along the guide members 504.

A coupling member 510 transmits driving force generated by the vibration-type actuator to the lens holding member 505 and is attached to and fits into the lens holding member 505. With this configuration, the lens holding member 505 can smoothly move in the both directions along the two guide members 504, together with the moving chassis 502.

A sensor 508 is arranged to detect a position of the lens holding member 505 on the guide members 504 by reading the positional information based on a scale 509 attached to a side face of the lens holding member 505. As described above, these members are assembled to configure the focus lens portion of the lens barrel apparatus.

While, in the above-described embodiment, although the lens barrel apparatus used in a single-lens reflex camera is described as an optical device, the present embodiment is applicable to various types of optical devices equipped with a vibration-type actuator, regardless of the type of camera, including compact cameras in which the lens and camera body are integrated, electronic still cameras, and the like.

As another configuration, the vibration-type actuator may include one contact member and a plurality of vibration members commonly in contact with the one contact member. In this vibration-type actuator, vibration generated by the plurality of vibration members cause the contact member to move relative to the plurality of vibration members.

Further, as an application example of the vibration-type actuator according to the present invention, the vibration-type actuator applied to a medical-use apparatus or an apparatus used in the engineering field may be considered. Specifically, the apparatus includes an elongated member, a wire inserted into the elongated member and fixed to one part of the elongated member, and the above-described vibration-type actuator for driving the wire. In this apparatus, the above-described vibration-type actuator is included in a wire-drive actuator which drives the wire to curve the elongated member.

[Examples]

Next, the vibration-type actuator and the vibration member according to the present invention will be described through examples. However, the present invention is not limited to the following examples.

[Example 1]

A piezoelectric material having a manufacturing composition 1 described in Table 2 was obtained by sintering a metal-oxide powder at 1340°C. The manufacturing composition 1 is a composition defined by the general formula (1), and values "x", "y", and "a" illustrated in Table 2 respectively correspond to the values of the above-described general expression 1.

After the obtained piezoelectric material was almost uniformly ground and polished to a thickness of approximately 0.5 mm, the piezoelectric material was formed into a ring shape having an outer diameter of 62 mm and an inner diameter of 54 mm. The driving phase electrode 101e and the non-driving phase electrodes 101f illustrated in Fig. 1C were formed on one side of the piezoelectric material which had been formed into a ring shape. Silver paste was applied to the piezoelectric material 102 by screen printing, and the silver paste was dried and baked, so that the electrodes were formed.

Next, an adhesive agent was applied to the elastic member 103 consisting of SUS420J2, and the elastic member 103 was pressed and bonded on the piezoelectric material 102 on which the electrodes had been formed. The ring-shaped piezoelectric material and the ring-shaped elastic member were arranged by using a positioning jig, so that the centers of the ring shapes coincided with each other. Next, thermal treatment for hardening the adhesive agent was performed. The piezoelectric material, on which the elastic member had been pressed and bonded, was heated to a temperature T1 (T1 = 160°C) and held for 180 sec., cooled to a room temperature, and released from a pressed state. In this way, a vibration member was obtained. Next, a flexible printed circuit (FPC), on which anisotropic conductive paste (ACP) had been applied, was thermally pressed and bonded on the electrodes formed on the piezoelectric material. This thermal press bonding was performed under the conditions of a temperature T2 (T2 = 140°C) and a retention time of 20 sec.

Thereafter, the elastic member consisting of SUS420J2 was grounded, and polarization treatment was performed by alternately applying voltages of different polarities to the adjacent driving phase electrodes 101e. In the polarization treatment, a plurality of external electrodes connected to a power source was brought into contact with an electrode used as a sensor, from among the driving phase electrodes 101e and the non-driving phase electrodes 101f. Then, the piezoelectric material was heated to a temperature T3 (T3 = 100°C), and an electric field corresponding to 2 kilovolts per millimeter (kV/mm) was applied for thirty minutes, and after cooling to 40°C in forty minutes while the electric field was applied, voltage application was terminated.

Thereafter, the first electrode 101a and the second electrode 101b were printed and dried. In this way, a vibration member was obtained. In the process of drying, in order to prevent depolarization of the piezoelectric material, the piezoelectric material was held at a temperature of lower than 80°C. A vibration-type actuator was manufactured by causing the obtained vibration member to be in pressure contact with a contact member (rotor) made of SUS420J2. In this process, a foamed member was disposed between the vibration member and a biasing member.

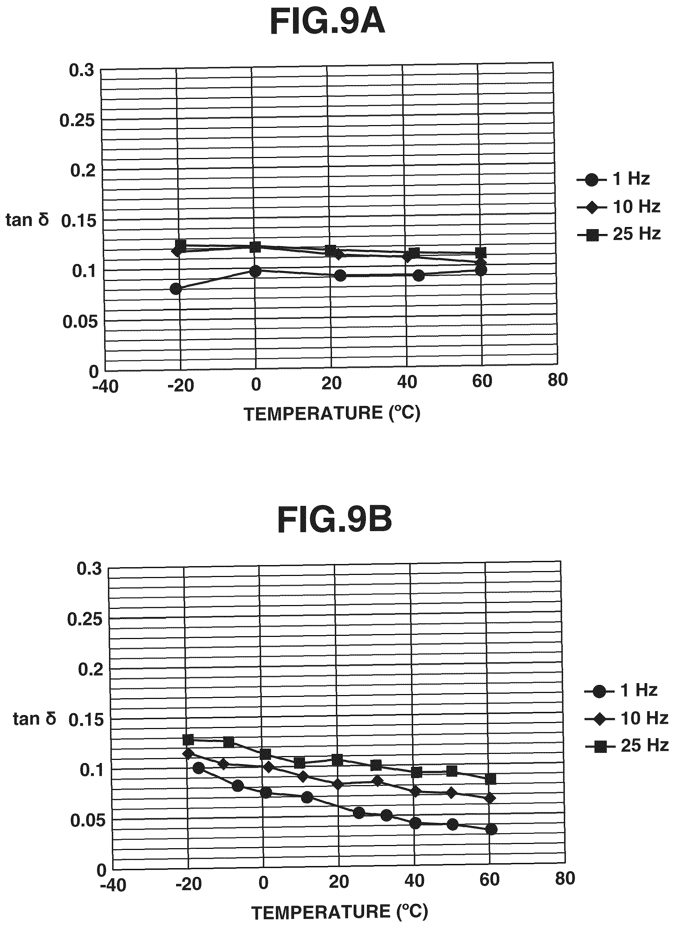

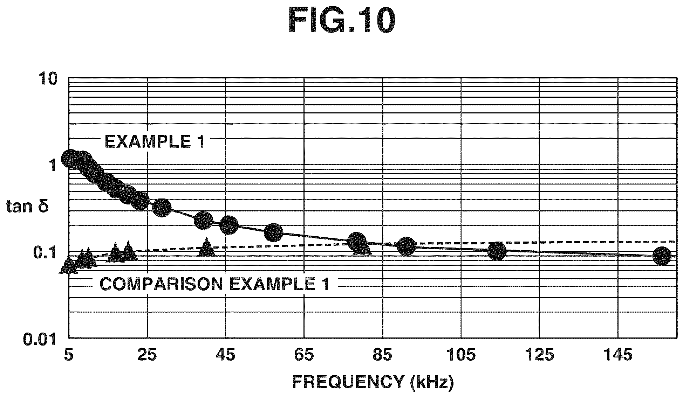

Measurement results of viscoelastic properties of the foamed member are illustrated in Fig. 9B, and a synthetic curve is illustrated in Fig. 10. Piezoelectric materials and properties of foamed members are illustrated in Table 1. A foamed member A used in the example 1 was made of silicone rubber, and the closed-cell bubbles accounted for 50% or more of the bubbles. Further, a loss coefficient $\tan\delta$ of the foamed member at a frequency of 1 Hz, measured at a temperature of -20°C, was greater than a loss coefficient $\tan\delta$ at a frequency of 10 Hz, measured at a temperature of 40°C.

[Table 1]

|  | Piezoelectric Material | Foamed Member | | | | | |
|---|---|---|---|---|---|---|---|
|  | Shape | Type | Average Equivalent Circle Diameter ($\mu$m) | Thickness (mm) | Skin Layer | Viscoelastic Property |
| Example 1 | Ring Shape | Foamed Member A | 215 | 1 | Present | $\tan\delta$ (-20°C, 1 Hz) > $\tan\delta$ (40°C, 10 Hz) |
| Example 2 | Rectangle | Foamed Member A | 215 | 1 | Present | $\tan\delta$ (-20°C, 1 Hz) > $\tan\delta$ (40°C, 10 Hz) |
| Example 3 | Rectangle | Foamed Member B | 170 | 2 | Absent | $\tan\delta$ (-20°C, 1 Hz) > $\tan\delta$ (40°C, 10 Hz) |

(continued)

|  | Piezoelectric Material | Foamed Member | | | | | |
|---|---|---|---|---|---|---|---|
|  | Shape | Type | Average Equivalent Circle Diameter ($\mu$m) | Thickness (mm) | Skin Layer | Viscoelastic Property |
| Example 4 | Rectangle | Foamed Member C | 210 | 2 | Present | tan $\delta$ (-20°C, 1 Hz) > tan $\delta$ (40°C, 10 Hz) |
| Example 5 | Rectangle | Foamed Member D | 435 | 2 | Absent | tan $\delta$ (-20°C, 1 Hz) > tan $\delta$ (40°C, 10 Hz) |
| Comparison Example 1 | Ring Shape | Foamed Member E | 315 | 2 | Absent | tan $\delta$ (-20°C, 1 Hz) < tan $\delta$ (40°C, 10 Hz) |
| Comparison Example 2 | Rectangle | Foamed Member E | 315 | 2 | Absent | tan $\delta$ (-20°C, 1 Hz) < tan $\delta$ (40°C, 10 Hz) |

(Example 2)

A vibration-type actuator was manufactured by a method similar to the method used in Example 1, except that a shape of a piezoelectric material was different from the shape of the piezoelectric material in Example 1.

Similar to Example 1, a piezoelectric material having the manufacturing composition 1 was obtained. After the obtained piezoelectric material was almost uniformly ground and polished to a thickness of 0.35 mm, the piezoelectric material was formed into a rectangular shape having a size of 8.9 mm $\times$ 5.7 mm. The first to the third electrodes illustrated in Fig. 3 were formed on both surfaces of the rectangular piezoelectric material by a method similar to the method used in Example 1.

Next, an adhesive agent was applied to an elastic member consisting of SUS420J2, and the elastic member was pressed and bonded on the rectangular-shape piezoelectric material on which the electrodes were formed. The used elastic member had a rectangular portion of 9.1 mm $\times$ 5.8 mm, larger than the piezoelectric material, and a thickness of the elastic member was 0.25 mm to 0.30 mm. The rectangular piezoelectric material and the elastic member were arranged by using a positioning jig, so that the centers of the rectangular portions coincided with each other, and the sides of the rectangular portions were parallel to each other. The piezoelectric material in a pressed state was heated to a temperature T1 (T1 = 160°C) and held for 180 sec., cooled to a room temperature, and pressure was released. In this way, a vibration member was obtained.

Next, by using an iron heated to a temperature T2 (T2 = 140°C), an FPC on which ACP was applied was pressed and bonded on the piezoelectric material for twenty seconds, so that the FPC was thermally pressed and bonded to the electrodes formed on the piezoelectric material.

Next, polarization treatment was performed on the piezoelectric material. In the polarization treatment, the elastic member was grounded, and respective external electrodes connected to a power source were brought into contact with the first and the second electrodes. Although the FPC was connected to the first and the second electrodes, part of the first and the second electrodes was not covered with the FPC, and thus the external electrodes used for the polarization treatment were in contact with that exposed part.

Thereafter, the piezoelectric material was heated to a temperature T3 (T3 = 100°C), and an electric field corresponding to 2 kV/mm was applied for thirty minutes. Then, after the piezoelectric material was cooled to 40°C in forty minutes while the electric field was applied, voltage application was terminated. A vibration-type actuator was manufactured by causing the vibration member obtained by the above-described process to be pressed against and brought into contact with a contact member (slider) made of SUS420J2. In this process, a foamed member was disposed between the vibration member and a biasing member.

Piezoelectric materials and properties of foamed members are illustrated in Table 1. In the example 2, the foamed member A as in Example 1 was used.

(Comparison Example 1)

A vibration-type actuator was manufactured by a method similar to the method used in Example 1, except that a foamed member E illustrated in Table 1 was disposed between the vibration member and the biasing member. Measurement results of the viscoelastic properties of the foamed member E of Comparison Example 1 are illustrated in Fig. 9A. A synthetic curve of the foamed member E of Comparison Example 1 is illustrated in Fig. 10. The foamed member E was made of silicone rubber, and the closed-cell bubbles accounted for 50% or more of the bubbles. Further, a loss coefficient $\tan\delta$ of the foamed member at a frequency of 1 Hz, measured at a temperature of -20°C, was smaller than a loss coefficient $\tan\delta$ at a frequency of 10 Hz, measured at a temperature of 40°C.

(Comparison Example 2)

A vibration-type actuator was manufactured by a method similar to the method used in Example 2, except that the foamed member E was disposed between the vibration member and the biasing member.

(Evaluation Method of Vibration-Type Actuator)

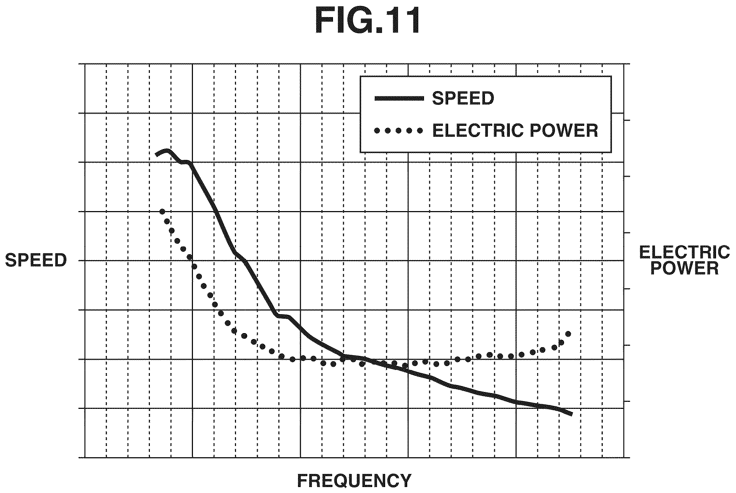

With respect to each of the vibration-type actuators of Examples and Comparison Examples, driving test was performed by applying alternating voltage with an amplitude of 130 Peak-to-Peak Voltage (Vpp) to the first and the second electrodes. The phase difference between the voltages of the first and the second electrodes were -90° and 90°, respectively.
When a frequency of the alternating voltage was swept toward a resonance frequency from a frequency higher than resonance frequencies of the vibration mode A and the vibration mode B, the contact member was driven in a direction according to the phase difference of the alternating voltage, and stopped after the speed reached the maximum speed. For convenience, travelling directions when the phase differences are -90°C and 90°C are referred to as "reverse direction" and "forward direction", respectively. A maximum speed of the vibration-type actuator and a frequency at which the speed of the vibration-type actuator reached the maximum speed were measured by a sensor. Power (rated power) at a rated speed lower than the maximum speed was calculated from electric current flowing in a driving circuit.
Examples of measurement results of speed and power with respect to the frequency are illustrated in Fig. 11. The maximum speed and the rated power were measured in the environmental atmosphere at a temperature of 20°C, and average values in the reverse direction and the forward direction were calculated. The maximum speed and the rated power representing driving performance, acquired in Example 1 and Comparison Example 1 were equivalent. Further, in order to check the unwanted vibration damping capability, in each of Example 1 and Comparison Example 1, an electric current value acquired when a frequency of 30 kHz was input as a driving frequency was analyzed by FFT analysis. In Example 1, a frequency at one-half of 30 kHz, i.e., the unwanted vibration component, was reduced. However, in Comparison Example 1, no change was observed in the unwanted vibration component.
The maximum speed and the rated power representing driving performance, acquired in Example 2 and Comparison Example 2 were equivalent. Further, in order to check the unwanted vibration damping capability, in each of Example 2 and Comparison Example 2, an electric current value acquired when a frequency of 104 kHz was input as a driving frequency was analyzed by FFT analysis. In Example 2, the unwanted vibration component at one-half of 104 kHz was reduced. However, in Comparison Example 2, no change was observed in the unwanted vibration component.

(Example 3 to Example 5)

A vibration-type actuator in each of Examples 3 to 5 was manufactured through a method similar to the method used in Example 2, except for a type of a foamed member disposed between the vibration member and the biasing member, illustrated in Table 1. Each of the foamed members was made of silicone rubber, and the closed-cell bubbles accounted for 50% or more of the bubbles. Viscoelastic properties of each of the foamed member were similar to the viscoelastic properties in Example 1. A loss coefficient $\tan\delta$ at a frequency of 1 Hz, measured at a temperature of -20°C, was greater than a loss coefficient $\tan\delta$ at a frequency of 10 Hz, measured at a temperature of 40°C. Further, in order to check the unwanted vibration damping capability, in each of Examples 3 to 5, an electric current value acquired when a frequency of 104 kHz was input as a driving frequency was analyzed by FFT analysis. In each of Examples 3 to 5, it was confirmed that the unwanted vibration component at one-half of 104 kHz was reduced.

(Example 6)

By mechanically connecting the vibration-type actuator manufactured in Example 2 with an optical member, the optical device in Fig. 8 was manufactured. Based on positional information provided to an encoder configured with a sensor and a scale, the vibration-type actuator and the optical member connected to the vibration-type actuator were precisely driven to target positions by controlling the alternating voltage applied to the piezoelectric material. In this optical device, an optical lens was connected to the vibration-type actuator, and it was confirmed that the optical device has an auto-focus function.

While each of the above-described examples was the case using Manufacturing Composition 1 as an example, even with the case using any of Manufacturing Compositions 2 to 46 and a piezoelectric zirconate titanate (PZT) material, it was found that, similar to the Example 2, the unwanted vibration component at one-half of the driving frequency was reduced in the driving properties of the vibration-type actuator according to the present invention.

As described above, it is found that an effect of reducing unwanted vibration can be acquired by making a loss coefficient tan$\delta$ of the foamed member in a frequency of 1 Hz, measured at a temperature of -20°C, be greater than a loss coefficient tan$\delta$ in a frequency of 10 Hz, measured at a temperature of 40°C. With this configuration, it is possible to provide a vibration-type actuator capable of maintaining stable driving properties for a long period of time, while suppressing a decrease in driving efficiency and generation of abnormal noise (squealing).

[Table 2]

| | x | y | $\alpha$ | Contained amount of Mn (part-by-weight) | Contained amount of Bi (part-by-weight) |
|---|---|---|---|---|---|
| Manufacturing Composition 1 | 0.140 | 0.080 | 0.9985 | 0.140 | 0.000 |
| Manufacturing Composition 2 | 0.020 | 0.020 | 1.002 | 0.10 | 0.00 |
| Manufacturing Composition 3 | 0.095 | 0.060 | 1.001 | 0.08 | 0.00 |
| Manufacturing Composition 4 | 0.125 | 0.090 | 1.000 | 0.06 | 0.00 |
| Manufacturing Composition 5 | 0.095 | 0.030 | 1.002 | 0.08 | 0.00 |
| Manufacturing Composition 6 | 0.095 | 0.095 | 0.999 | 0.24 | 0.85 |
| Manufacturing Composition 7 | 0.110 | 0.075 | 0.9994 | 0.240 | 0.170 |
| Manufacturing Composition 8 | 0.110 | 0.075 | 0.9994 | 0.240 | 0.340 |
| Manufacturing Composition 9 | 0.110 | 0.075 | 0.9969 | 0.240 | 0.510 |
| Manufacturing Composition 10 | 0.110 | 0.075 | 0.9994 | 0.040 | 0.550 |
| Manufacturing Composition 11 | 0.120 | 0.080 | 0.9994 | 0.240 | 0.340 |
| Manufacturing Composition 12 | 0.125 | 0.020 | 1.003 | 0.08 | 0.00 |
| Manufacturing Composition 13 | 0.125 | 0.050 | 1.001 | 0.06 | 0.00 |
| Manufacturing Composition 14 | 0.130 | 0.075 | 0.9994 | 0.240 | 0.170 |
| Manufacturing Composition 15 | 0.140 | 0.075 | 1.003 | 0.02 | 0.00 |
| Manufacturing Composition 16 | 0.140 | 0.075 | 1.000 | 0.07 | 0.00 |
| Manufacturing Composition 17 | 0.140 | 0.075 | 1.001 | 0.08 | 0.00 |
| Manufacturing Composition 18 | 0.140 | 0.078 | 0.9955 | 0.160 | 0.181 |
| Manufacturing Composition 19 | 0.140 | 0.075 | 1.0004 | 0.160 | 0.094 |
| Manufacturing Composition 20 | 0.140 | 0.075 | 1.0004 | 0.160 | 0.189 |
| Manufacturing Composition 21 | 0.140 | 0.075 | 1.0004 | 0.160 | 0.239 |
| Manufacturing Composition 22 | 0.140 | 0.085 | 1.0004 | 0.160 | 0.539 |
| Manufacturing Composition 23 | 0.140 | 0.080 | 1.0004 | 0.140 | 0.289 |
| Manufacturing Composition 24 | 0.140 | 0.080 | 1.0004 | 0.140 | 0.339 |
| Manufacturing Composition 25 | 0.140 | 0.075 | 1.0004 | 0.160 | 0.094 |
| Manufacturing Composition 26 | 0.155 | 0.020 | 1.005 | 0.15 | 0.00 |
| Manufacturing Composition 27 | 0.155 | 0.065 | 1.000 | 0.02 | 0.00 |
| Manufacturing Composition 28 | 0.155 | 0.065 | 1.001 | 0.06 | 0.00 |
| Manufacturing Composition 29 | 0.155 | 0.069 | 1.004 | 0.18 | 0.00 |

(continued)

| | x | y | $\alpha$ | Contained amount of Mn (part-by-weight) | Contained amount of Bi (part-by-weight) |
|---|---|---|---|---|---|
| Manufacturing Composition 30 | 0.155 | 0.078 | 0.9994 | 0.240 | 0.170 |
| Manufacturing Composition 31 | 0.160 | 0.059 | 1.009 | 0.40 | 0.00 |
| Manufacturing Composition 32 | 0.160 | 0.078 | 1.0042 | 0.360 | 0.170 |
| Manufacturing Composition 33 | 0.160 | 0.085 | 0.9971 | 0.180 | 0.170 |
| Manufacturing Composition 34 | 0.170 | 0.075 | 0.9998 | 0.140 | 0.189 |
| Manufacturing Composition 35 | 0.170 | 0.075 | 1.0042 | 0.360 | 0.170 |
| Manufacturing Composition 36 | 0.175 | 0.090 | 1.007 | 0.10 | 0.00 |
| Manufacturing Composition 37 | 0.187 | 0.060 | 1.009 | 0.24 | 0.00 |
| Manufacturing Composition 38 | 0.187 | 0.060 | 1.010 | 0.40 | 0.00 |
| Manufacturing Composition 39 | 0.187 | 0.077 | 0.9994 | 0.240 | 0.170 |
| Manufacturing Composition 40 | 0.200 | 0.035 | 1.006 | 0.20 | 0.00 |
| Manufacturing Composition 41 | 0.200 | 0.090 | 1.006 | 0.26 | 0.00 |
| Manufacturing Composition 42 | 0.200 | 0.075 | 0.9994 | 0.240 | 0.170 |
| Manufacturing Composition 43 | 0.220 | 0.082 | 0.9994 | 0.240 | 0.170 |
| Manufacturing Composition 44 | 0.220 | 0.030 | 1.005 | 0.22 | 0.00 |
| Manufacturing Composition 45 | 0.260 | 0.070 | 1.005 | 0.28 | 0.00 |
| Manufacturing Composition 46 | 0.300 | 0.095 | 1.008 | 0.30 | 0.00 |

The disclosure of the present embodiments includes the following structures and methods.

(Configuration 1)

A vibration-type actuator comprising:

a vibration member configured to include an electric-mechanical energy conversion element and an elastic member having a plate portion and projected portions which project in a same direction from a surface of the plate portion; a contact member configured to be in contact with the projected portions of the vibration member and move relative to the vibration member; a foamed member configured to be in contact with the vibration member; and a biasing member configured to press the vibration member toward the contact member via the foamed member, wherein, in a case where loss coefficient tanδ of the foamed member is measured by viscoelastic measurement in which vibration is applied to the foamed member, the loss coefficient tanδ of the foamed member measured at -20°C with vibration applied at a frequency of 1 Hz, is greater than the loss coefficient tanδ of the foamed member, measured at 40°C with vibration applied at a frequency of 10 Hz.

(Configuration 2)

The vibration-type actuator according to Configuration 1, wherein the foamed member includes a siloxane bond of silicon and oxygen (Si-O-Si).

(Configuration 3)

The vibration-type actuator according to Configuration 1 or 2, wherein the foamed member is a sponge containing silicone rubber.

17

(Configuration 4)

The vibration-type actuator according to any one of Configuration 1 to 3, wherein an average equivalent circle diameter of bubbles contained in the foamed member is greater than 120 $\mu$m.

(Configuration 5)

The vibration-type actuator according to any one of Configurations 1 to 4, wherein loss coefficient tan$\delta$ of the foamed member, subjected to vibration at a frequency of 10 Hz and measured at -20°C, is 0.1 or more.

(Configuration 6)

The vibration-type actuator according to any one of Configurations 1 to 5, wherein, in a synthetic curve which is acquired according to a time-temperature superposition principle with a reference temperature of 23°C, the foamed member has a loss coefficient tan$\delta$ of 0.2 or more in a state where vibration at a frequency of 30 Hz is applied.

(Configuration 7)

The vibration-type actuator according to any one of Configurations 1 to 6, wherein, in a synthetic curve which is acquired according to a time-temperature superposition principle, the foamed member has a frequency range in which the loss coefficient decreases as the frequency increases.

(Configuration 8)

The vibration-type actuator according to any one of Configurations 1 to 7,

wherein the electric-mechanical energy conversion element includes a piezoelectric material and an electrode, and wherein lead content of the piezoelectric material is 1000 ppm or less.

(Configuration 9)

The vibration-type actuator according to any one of Configurations 1 to 8, wherein the plate portion has a rectangular shape.

(Configuration 10)

The vibration-type actuator according to any one of Configurations 1 to 9, wherein the elastic member has two projected portions.

(Configuration 11)

The vibration-type actuator according to any one of Configurations 1 to 10, wherein the foamed member is smaller than the electric-mechanical energy conversion element.

(Configuration 12)

The vibration-type actuator according to any one of Configurations 1 to 11, wherein the foamed member is smaller than the elastic member.

(Configuration 13)

The vibration-type actuator according to any one of Configurations 1 to 12, wherein a main component of the electric-mechanical energy conversion element is a barium titanate series.

(Configuration 14)

The vibration-type actuator according to any one of Configurations 1 to 13, wherein a main component of the electric-mechanical energy conversion element is barium calcium zirconate titanate.

(Configuration 15)

An electronic device comprising:

a member; and
the vibration-type actuator according to any one of Configurations 1 to 14, disposed in the member.

(Configuration 16)

An optical device comprising:

at least any one of an optical element and an image sensor; and
the vibration-type actuator according to any one of Configurations 1 to 15 disposed in at least any one of the optical element and the image sensor.

This invention is not limited to the above-described embodiments, and various modifications and alterations can be made without departing from the spirit and scope of the invention. Accordingly, in order to publicly disclose the scope of the invention, the following claims are appended.

This application claims the benefit of Japanese Patent Application No. 2023-104194, filed June 26, 2023, which is hereby incorporated by reference herein in its entirety.

Reference Signs List

100 Vibration-type actuator

101 Electrode

101a First electrode

101b Second electrode

101c Third electrode

101d Fourth electrode

101e Driving phase electrode

101f Non-driving phase electrode

102 Piezoelectric material

103 Elastic member

104 Contact member

106 Projected portion

107 Supporting portion

108 Plate portion

110 Vibration member

120 Electric-mechanical energy conversion element

121 Biasing member

122 Foamed member

133 Bubble

134 Skin layer

501 Holding member

502 Moving chassis

503 Screw

504 Guide member

505 Lens holding member

506 Lens

507 Power supply member

508 Sensor

509 Scale

510 Coupling member

**Claims**

1. A vibration-type actuator comprising:

   a vibration member configured to include an electric-mechanical energy conversion element and an elastic member having a plate portion and projected portions which project in a same direction from a surface of the plate portion;
   a contact member configured to be in contact with the projected portions of the vibration member and move relative to the vibration member;
   a foamed member configured to be in contact with the vibration member; and
   a biasing member configured to press the vibration member toward the contact member via the foamed member, wherein, in a case where loss coefficient $\tan\delta$ of the foamed member is measured by viscoelastic measurement in which vibration is applied to the foamed member, the loss coefficient $\tan\delta$ of the foamed member measured at -20°C with vibration applied at a frequency of 1 Hz, is greater than the loss coefficient $\tan\delta$ of the foamed member, measured at 40°C with vibration applied at a frequency of 10 Hz.

2. The vibration-type actuator according to Claim 1, wherein the foamed member includes a siloxane bond of silicon and oxygen (Si-O-Si).

3. The vibration-type actuator according to Claim 1, wherein the foamed member is a sponge containing silicone rubber.

4. The vibration-type actuator according to Claim 1, wherein an average equivalent circle diameter of bubbles contained in the foamed member is greater than 120 $\mu$m.

5. The vibration-type actuator according to Claim 1, wherein loss coefficient $\tan\delta$ of the foamed member, subjected to vibration at a frequency of 10 Hz and measured at -20°C, is 0.1 or more.

6. The vibration-type actuator according to Claim 1, wherein, in a synthetic curve which is acquired according to a time-temperature superposition principle with a reference temperature of 23°C, the foamed member has a loss coefficient $\tan\delta$ of 0.2 or more in a state where vibration at a frequency of 30 Hz is applied.

7. The vibration-type actuator according to Claim 1, wherein, in a synthetic curve which is acquired according to a time-temperature superposition principle, the foamed member has a frequency range in which the loss coefficient decreases as the frequency increases.

8. The vibration-type actuator according to Claim 1,

   wherein the electric-mechanical energy conversion element includes a piezoelectric material and an electrode, and
   wherein lead content of the piezoelectric material is 1000 ppm or less.

9. The vibration-type actuator according to Claim 1, wherein the plate portion has a rectangular shape.

10. The vibration-type actuator according to Claim 1, wherein the elastic member has two projected portions.

11. The vibration-type actuator according to Claim 1, wherein the foamed member is smaller than the electric-mechanical energy conversion element.

12. The vibration-type actuator according to Claim 1, wherein the foamed member is smaller than the elastic member.

13. The vibration-type actuator according to Claim 1, wherein a main component of the electric-mechanical energy conversion element is a barium titanate series.

14. The vibration-type actuator according to Claim 1, wherein a main component of the electric-mechanical energy conversion element is barium calcium zirconate titanate.

15. An electronic device comprising:

    a member; and
    the vibration-type actuator according to Claim 1, disposed in the member.

16. An optical device comprising:

    at least any one of an optical element and an image sensor; and
    the vibration-type actuator according to Claim 1 disposed in at least any one of the optical element and the image sensor.

# FIG.1A

# FIG.1B

# FIG.1C

# FIG.1D

# FIG.1E

# FIG.1F

# FIG.2A

MODE A

# FIG.2B

MODE B

# FIG.3

133

# FIG.4A

# FIG.4B

# FIG.5

# FIG.6

FIG.7

# FIG.8

# FIG.9A

# FIG.9B

# FIG.10

# FIG.11

## INTERNATIONAL SEARCH REPORT

International application No.

**PCT/JP2024/022483**

### A. CLASSIFICATION OF SUBJECT MATTER

*H02N 2/04*(2006.01)i; *H02N 2/12*(2006.01)i
FI:   H02N2/04; H02N2/12

According to International Patent Classification (IPC) or to both national classification and IPC

### B. FIELDS SEARCHED

Minimum documentation searched (classification system followed by classification symbols)

H02N2/04; H02N2/12

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| A | JP 2014-220990 A (CANON KABUSHIKI KAISHA) 20 November 2014 (2014-11-20) paragraph [0060] | 1-16 |
| A | JP 2002-325469 A (ASMO CO., LTD.) 08 November 2002 (2002-11-08) paragraph [0030] | 1-16 |

☐ Further documents are listed in the continuation of Box C.      ☑ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **27 August 2024** | **10 September 2024** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (July 2022)

## INTERNATIONAL SEARCH REPORT
### Information on patent family members

International application No.

**PCT/JP2024/022483**

| Patent document cited in search report | | | Publication date (day/month/year) | Patent family member(s) | Publication date (day/month/year) |
|---|---|---|---|---|---|
| JP | 2014-220990 | A | 20 November 2014 | US 2014/0305247 A1 paragraph [0078] | |
| JP | 2002-325469 | A | 08 November 2002 | (Family: none) | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 3289371 A
- JP 2022083146 A
- JP 2023104194 A